# EUROPEAN PATENT APPLICATION

(11) **EP 4 660 747 A1**
(43) Date of publication of application: **10.12.2025**
(21) Application number: 24807319.9
(22) Date of filing: 27.02.2024
(51) Int. Cl.: G06F 1/16, G09F 9/30, H04M 1/02

(54) **ELECTRONIC APPARATUS COMPRISING FLEXIBLE DISPLAY**

(30) Priority: 17.05.2023 KR 20230063874; 23.06.2023 KR 20230080765
(71) Applicant: Samsung Electronics Co., Ltd., Suwon-si, Gyeonggi-do 16677 (KR)
(72) Inventor: KIM, Taejeong, Suwon-si Gyeonggi-do 16677 (KR); KIM, Minsoo, Suwon-si Gyeonggi-do 16677 (KR); KIM, Yongwoon, Suwon-si Gyeonggi-do 16677 (KR); BAE, Jaehyun, Suwon-si Gyeonggi-do 16677 (KR); LEE, Soogyu, Suwon-si Gyeonggi-do 16677 (KR); HAN, Yonggil, Suwon-si Gyeonggi-do 16677 (KR)
(74) Representative: Gulde & Partner
(86) International application number: PCT/KR2024/002515
(87) International publication number: WO 2024/237437

(57) **Abstract**

An electronic device according to an embodiment comprises: a housing assembly including a first housing and a second housing; a flexible display disposed in the first housing and the second housing and partially bent according to a sliding movement of the second housing to be inserted into or withdrawn from the housing assembly; a foreign substance inflow prevention part disposed between the housing assembly and the flexible display so as to prevent the inflow of foreign substances, and configured to vary in thickness by an applied voltage; and a processor configured to control the voltage applied to the foreign substance inflow prevention part according to a movement of the second housing.

## Description

### [Technical Field]

Various embodiments of the disclosure relate to an electronic device including a flexible display.

### [Background Art]

Recently, there is increasing interest in bendable electronic devices (also referred to as 'flexible electronic devices') including a bendable flexible display (simply 'flexible display'). Flexible electronic devices may include, e.g., slidable electronic devices, foldable electronic devices, or rollable electronic devices.

In slidable electronic devices, a portion of a flexible display is retracted or extracted according to the movement of a housing, and a gap of a predetermined interval may be formed in a portion where the flexible display is retracted or extracted. The electronic device may include a foreign object prevention means for preventing foreign objects from entering the gap.

The above-described information may be provided as related art for the purpose of helping understanding of the disclosure. No claim or determination is made as to whether any of the foregoing is applicable as background art in relation to the disclosure.

### [Disclosure of Invention]

### [Solution to Problems]

The electronic device may include physical means such as a seal, a sweeper, or a scraper as the foreign object prevention means. Such physical means should tightly contact the display surface to block and discharge the foreign objects, which causes friction during the retraction or extraction operation, and surface damage may be caused by the friction. Various embodiments of the disclosure may provide an electronic device including a foreign object prevention structure that may selectively contact a surface of the flexible display.

An electronic device according to an embodiment of the disclosure may comprise a housing assembly including a first housing and a second housing slidably coupled to the first housing, a flexible display disposed on the first housing and the second housing, and configured so that a portion the flexible display is bent to be retracted into or extracted from an interior of the housing assembly according to a sliding movement of the second housing, a foreign substance blocking portion disposed between the housing assembly and the flexible display to prevent ingress of a foreign object, and configured to have a variable thickness in response to an applied voltage, and a processor configured to control a voltage applied to the foreign substance blocking portion according to a movement of the second housing.

According to various embodiments proposed in the disclosure, the electronic device includes a foreign object prevention structure that is spaced apart from the flexible display so that friction does not occur on the surface of the flexible display during the retraction or extraction operation, thereby preventing scratches or damage to the flexible display.

Effects achievable in example embodiments of the disclosure are not limited to the above-mentioned effects, but other effects not mentioned may be apparently derived and understood by one of ordinary skill in the art to which example embodiments of the disclosure pertain, from the following description. In other words, unintended effects in practicing embodiments of the disclosure may also be derived by one of ordinary skill in the art from example embodiments of the disclosure.

### [Brief Description of Drawings]

FIG. 1 is a view illustrating an electronic device in a network environment according to various embodiments.
FIG. 2A is a front view illustrating an electronic device in a first state according to an embodiment.
FIG. 2B is a rear view illustrating an electronic device in a first state according to an embodiment.
FIG. 3A is a front view illustrating an electronic device in a second state according to an embodiment.
FIG. 3B is a rear view illustrating an electronic device in a second state according to an embodiment.
FIG. 4 is an exploded perspective view illustrating an electronic device according to an embodiment.
FIG. 5A is a cross-sectional view illustrating an example of cutting the electronic device according to an embodiment along line A-A' of FIG. 2A.
FIG. 5B is a cross-sectional view illustrating an example of cutting the electronic device according to an embodiment along line B-B' of FIG. 3A.
FIG. 6 is a view illustrating an exploded state of some components of an electronic device according to an embodiment.
FIG. 7 is a cross-sectional perspective view illustrating an electronic device according to an embodiment.
FIGS. 8 and 9 are partial cross-sectional views illustrating an electronic device according to an embodiment.
FIG. 10 is a flowchart illustrating a control method of an electronic device according to an embodiment.
FIGS. 11 and 12 are partial cross-sectional views illustrating an electronic device according to an embodiment.
FIG. 13 is a perspective view illustrating an auxiliary foreign substance blocking portion according to an embodiment.
FIG. 14 is a partial cross-sectional view illustrating an electronic device according to an embodiment.
FIG. 15 is a partial cross-sectional view illustrating an electronic device according to an embodiment.
Reference may be made to the accompanying drawings in the following description, and specific examples that may be practiced are shown as examples within the drawings. Other examples may be utilized and structural changes may be made without departing from the scope of the various examples.

### [Mode for the Invention]

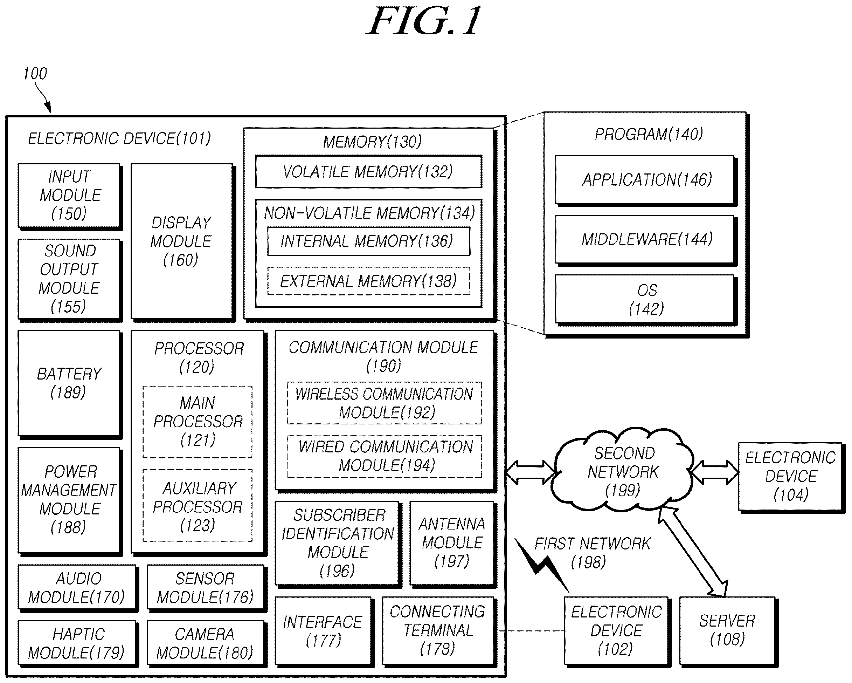

Various embodiments of the disclosure are merely exemplified herein with reference to FIGS. 1 to 15, to describe the principle of the disclosure, and should not be interpreted as limiting the scope of the disclosure. Those skilled in the art will understand that the principle of the disclosure may be implemented in any appropriately disposed system or device.

Hereinafter, embodiments of the disclosure are described in detail with reference to the drawings so that those skilled in the art to which the disclosure pertains may easily practice the disclosure. However, the disclosure may be implemented in other various forms and is not limited to the embodiments set forth herein. The same or similar reference denotations may be used to refer to the same or similar elements throughout the specification and the drawings. Further, for clarity and brevity, no description is made of well-known functions and configurations in the drawings and relevant descriptions.

FIG. 1 is a block diagram illustrating an electronic device in a network environment according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the sub processor 123, the sub processor 123 may be configured to use lower power than the main processor 121 or to be specified for a designated function. The sub processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operation state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

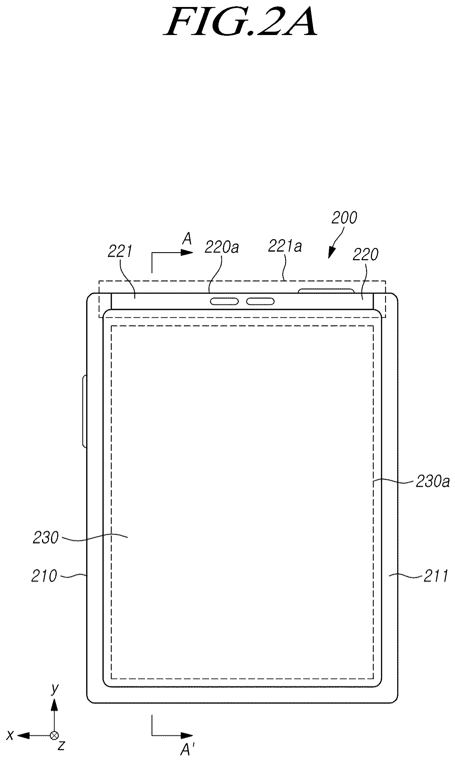

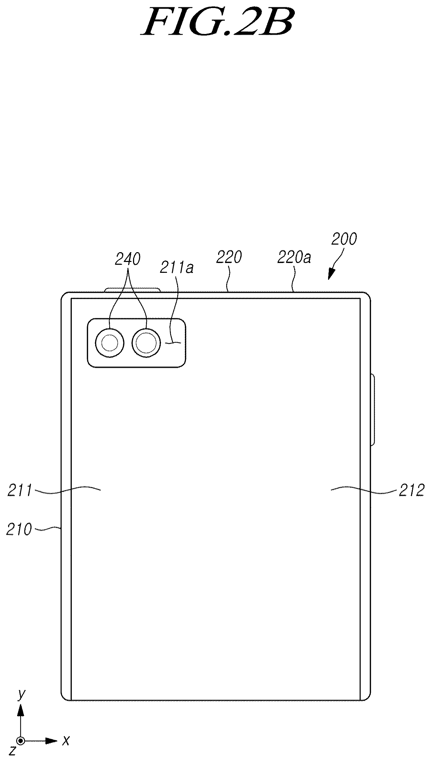

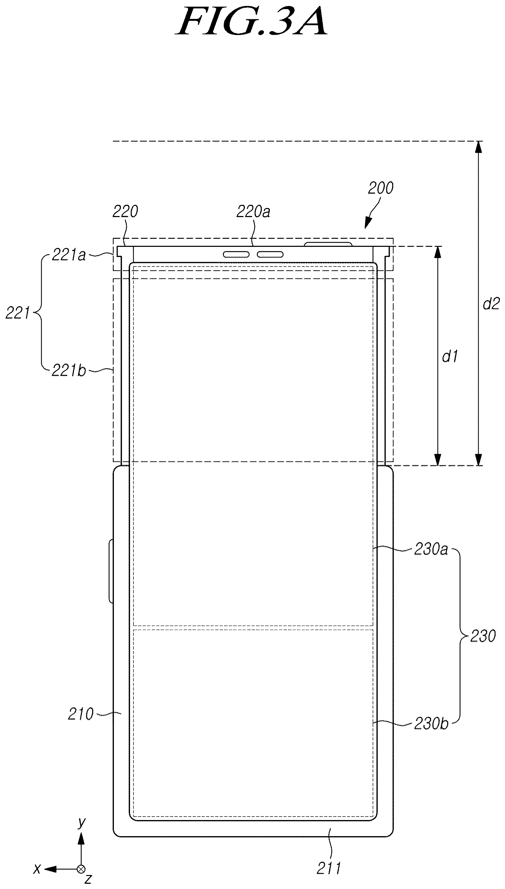

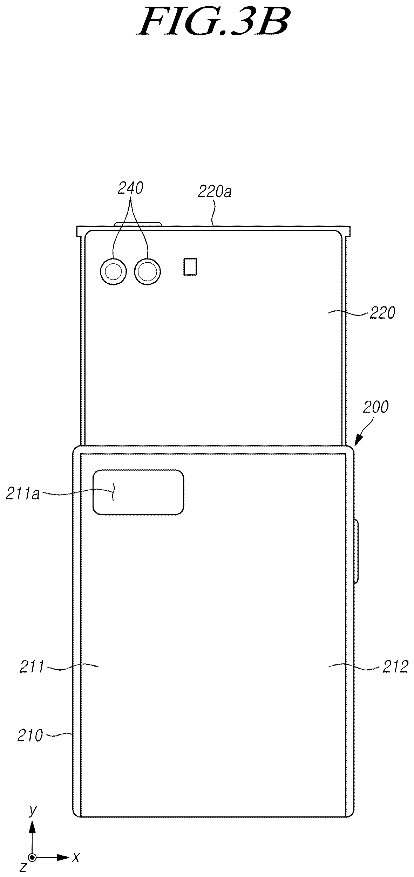

FIG. 2A is a front view illustrating an electronic device in a first state according to an embodiment. FIG. 2B is a rear view illustrating an electronic device in a first state according to an embodiment. FIG. 3A is a front view illustrating an electronic device in a second state according to an embodiment. FIG. 3B is a rear view illustrating an electronic device in a second state according to an embodiment.

Referring to FIGS. 2A, 2B, 3A, and 3B, an electronic device 200 (e.g., the electronic device 101 of FIG. 1) according to an embodiment may include a housing assembly 210, 220, a display 230 (e.g., the display module 160 of FIG. 1), and a camera 240 (e.g., the camera module 180 of FIG. 1). The housing assembly 210, 220 may include a first housing 210 and a second housing 220. The first housing 210 and the second housing 220 may be coupled to be movable with respect to each other. According to an embodiment, the second housing 220 may be slidable with respect to the first housing 210. For example, the second housing 220 may move with respect to the first housing 210 along a first direction (e.g., +y direction) in a range of a designated distance. In a case where the second housing 220 moves along the first direction, the distance between a side surface 220a of the second housing 220 facing the first direction and the first housing 210 may increase. As another example, the second housing 220 may move with respect to the first housing 210 along a second direction (e.g., -y direction) opposite to the first direction in a range of a designated distance. In a case where the second housing 220 moves along the second direction, the distance between the side surface 220a of the second housing 220 facing the first direction and the first housing 210 may decrease. According to an embodiment, the second housing 220 may perform linear reciprocating motion with respect to the first housing 210 by sliding relative to the first housing 210. For example, at least a portion of the second housing 220 may be retractable into the first housing 210 or extractable from the first housing 210.

According to an embodiment, the electronic device 200 may be referred to as a "slidable electronic device" as the second housing 220 is designed to be slidable with respect to the first housing 210. According to an embodiment, the electronic device 200 may be referred to as a "rollable electronic device" as at least a portion of the display 230 is designed to be rolled inside the second housing 220 (or first housing 210) based on the sliding movement of the second housing 220.

According to an embodiment, the first state of the electronic device 200 may be defined as a state in which the second housing 220 has moved in the second direction (e.g., contracted state, closed state, retracted state, or slide-in state). For example, in the first state of the electronic device 200, the second housing 220 may not be substantially movable in the second direction. In the first state of the electronic device 200, the distance between the side surface 220a of the second housing 220 and the first housing 210 may not be decreased. As another example, in the first state of the electronic device 200, a portion of the second housing 220 may not be retractable. According to an embodiment, the first state of the electronic device 200 may be a state in which a second area 230b of the display 230 is not visually exposed outside the electronic device 200. For example, in the first state of the electronic device 200, the second area 230b of the display 230 may be positioned inside an inner space (not illustrated) of the electronic device 200 formed by the first housing 210 and/or the second housing 220, and may not be visible from outside the electronic device 200.

According to an embodiment, the second state of the electronic device 200 may be defined as a state in which the second housing 220 has moved in the first direction (e.g., extracted state, open state, or slide-out state). For example, in the electronic device 200, the second housing 220 may not be substantially movable in the first direction. In the second state of the electronic device 200, the distance between the side surface 220a of the second housing 220 and the first housing 210 may not increase. As another example, in the second state of the electronic device 200, a portion of the second housing 220 may not be extractable from the first housing 210. According to an embodiment, the second state of the electronic device 200 may be a state in which the second area 230b of the display 230 is visually exposed outside the electronic device 200. For example, in the second state of the electronic device 200, the second area 230b of the display 230 may be extracted from the inner space of the electronic device 200 and be visible from outside the electronic device 200.

According to an embodiment, in a case where the second housing 220 moves from the first housing 210 in the first direction, at least a portion of the second housing 220 and/or the second area 230b of the display 230 may be extracted from the first housing 210 by an extraction length d1 corresponding to the moving distance of the second housing 220. According to an embodiment, the second housing 220 may reciprocate within a designated distance d2. According to an embodiment, the extraction length d1 may have a size of about 0 to a designated distance d2.

According to an embodiment, the state of the electronic device 200 may be convertible between the second state and/or the first state by manual operation by the user or by automatic operation by a driving module (not illustrated) disposed inside the first housing 210 or the second housing 220. According to an embodiment, the driving module may be triggered based on a user input. According to an embodiment, the user input for triggering the operation of the driving module may include a touch input, a force touch input, and/or a gesture input through the display 230. According to another embodiment, the user input for triggering the operation of the driving module may include a voice input or an input of a physical button exposed outside the first housing 210 or the second housing 220. According to an embodiment, the driving module may be driven in a semi-automatic manner where operation is triggered in a case where manual operation by external force from the user is detected.

According to an embodiment, the first state of the electronic device 200 may be referred to as a first shape, and the second state of the electronic device 200 may be referred to as a second shape. For example, the first shape may include a normal state, contracted state, or closed state, and the second shape may include an open state. According to an embodiment, the electronic device 200 may form a third state (e.g., intermediate state) that is between the first state and the second state. For example, the third state may be referred to as a third shape, and the third shape may include a free stop state.

According to an embodiment, the display 230 may be visible or viewable from outside through the front direction (e.g., -z direction) of the electronic device 200 to display visual information to the user. For example, the display 230 may include a flexible display (e.g., flexible display, extendable display, stretchable display, rollable display, or display assembly).

According to an embodiment, the display 230 may be disposed across the first housing 210 and the second housing 220. The display 230 may include a bendable flexible area (e.g., the second area 230b). A flexible area of the display 230, e.g., the second area 230b, may be configured so that a portion the display 230 is bent according to the sliding movement of the second housing 220 to be retracted into or extracted from the housing assembly 210, 220.

According to an embodiment, at least a portion of the display 230 may be disposed on the second housing 220 and may be extracted from an inner space (not illustrated) of the electronic device 200 or retracted into the inner space of the electronic device 200 according to the movement of the second housing 220. The inner space of the electronic device 200 may denote the space in the first housing 210 and the second housing 220 formed by the coupling of the first housing 210 and the second housing 220. Or, the inner space of the electronic device 200 may denote a space in the housing assembly 210, 220. For example, in the first state of the electronic device 200, at least a portion of the display 230 may be rolled and retracted into the inner space of the electronic device 200. If at least a portion of the display 230 is retracted into the inner space of the electronic device 200 and the second housing 220 moves in the first direction, at least a portion of the display 230 may be extracted from the inner space of the electronic device 200. As another example, in a case where the second housing 220 moves in the second direction, at least a portion of the display 230 may be retracted into the inner space of the electronic device 200 by rolling into the interior of the electronic device 200. As at least a portion of the display 230 is extracted or retracted, the area of the display 230 visible from outside the electronic device 200 may be extended or contracted. According to an embodiment, the display 230 may include a first area 230a and/or a second area 230b.

According to an embodiment, the first area 230a of the display 230 may refer to an area of the display 230 that is fixedly visible from outside the electronic device 200 regardless of whether the electronic device 200 is in the second state or the first state. For example, the first area 230a may refer to a partial area of the display 230 that does not roll into the inner space of the electronic device 200. According to an embodiment, the first area 230a may move together with the second housing 220 if the second housing 220 moves. For example, if the second housing 220 moves along the first direction or the second direction, the first area 230a may move along the first direction or the second direction on the front surface of the electronic device 200 together with the second housing 220.

According to an embodiment, the second area 230b of the display 230 may be retracted into the inner space of the electronic device 200 or extracted from the inner space of the electronic device 200 to the outside according to the movement of the second housing 220. For example, at least a portion of the second area 230b of the display 230 may be in a state retracted into the inner space of the electronic device 200 in a rolled state in the first state of the electronic device 200. The second area 230b of the display 230 may be retracted into the inner space of the electronic device 200 not to be visible from outside in the first state of the electronic device 200. As another example, the second area 230b of the display 230 may be in a state extracted from the inner space of the electronic device 200 in the second state of the electronic device 200. The second area 230b of the display 230 may be visible from outside the electronic device 200 in the second state.

According to an embodiment, in the first state of the electronic device 200, the area of the display 230 visible from outside the electronic device 200 may include only the first area 230a of the display 230. In the second state of the electronic device 200, the area of the display 230 visible from outside the electronic device 200 may include at least a portion of the first area 230a and the second area 230b of the display 230.

According to an embodiment, the first housing 210 of the electronic device 200 may include a first supporting member 211 surrounding the inner space of the first housing 210, a rear plate 212 covering the rear surface of the first supporting member 211, and a first side member 214 covering at least a portion of the edge of the first supporting member 211. According to an embodiment, the first supporting member 211 may be integrally formed with the first side member 214. The first supporting member 211 may extend from at least a portion of one surface of the first side member 214 facing the interior of the electronic device 200 into the interior of the electronic device 200. According to an embodiment, the first supporting member 211 and the first side member 214 may be integrally formed or formed of the same material.

According to an embodiment, the second housing 220 of the electronic device 200 may include a second supporting member 221 and a second side member 229 surrounding the inner space of the electronic device 200.

According to an embodiment, the second side member 229 may form at least a portion of the side surface of the second housing 220. The second supporting member 221 may support electronic components (e.g., the camera 240 and/or printed circuit board 224) disposed in the second housing 220. The second side member 229 may surround at least a portion of the second supporting member 221. According to an embodiment, the second supporting member 221 may be integrally formed with the second side member 229. The second supporting member 221 may extend from at least a portion of one surface of the second side member 229 facing the interior of the second housing 220 into the interior of the second housing 220. According to an embodiment, the second supporting member 221 and the second side member 229 may be integrally formed or formed of the same material.

According to an embodiment, the second supporting member 221 may include a first cover area 221a of the second supporting member 221 that is not inserted into the interior of the first housing 210, and a second cover area 221b that is inserted into or extracted from the interior of the first housing 210. The first cover area 221a of the second supporting member 221 may always be visible regardless of whether the electronic device 200 is in the second state or the first state. According to an embodiment, at least a portion of the first cover area 221a of the second supporting member 221 may form the side surface 220a of the second housing 220. According to an embodiment, the second cover area 221b of the second housing 220 may not be visible in the first state and may be visible in the second state.

The camera 240 may obtain an image of a subject based on receiving light from outside the electronic device 200. According to an embodiment, the camera 240 may include one or more lenses, an image sensor, and/or an image signal processor. According to an embodiment, the camera 240 may be disposed on the second housing 220 to face the rear surface of the electronic device 200 opposite to the front surface of the electronic device 200 where the first area 230a of the display 230 is disposed. For example, the camera 240 may be disposed on the second supporting member 221 of the second housing 220 and may be visible from outside the electronic device 200 through an opening 211a formed in the first supporting member 211 in a case where the electronic device 200 is in the first state. As another example, the camera 240 may be disposed on the second supporting member 221 of the second housing 220 and may not be visible from outside the electronic device 200 by being covered by the first supporting member 211 and/or the rear plate 212 in a case where the electronic device 200 is in the first state.

According to an embodiment, the camera 240 may include a plurality of cameras. For example, the camera 240 may include a wide-angle camera, ultra-wide-angle camera, telephoto camera, proximity camera, and/or depth camera. However, the camera 240 is not necessarily limited to including a plurality of cameras but may include one camera.

According to an embodiment, the camera 240 may further include a camera (not illustrated) facing the front surface of the electronic device 200 where the first area 230a of the display 230 is disposed. In a case where the camera 240 faces the front surface of the electronic device 200, the camera 240 may be an under display camera (UDC) disposed under the display 230 (e.g., in the +z direction from the display 230), but the disclosure is not limited thereto.

According to an embodiment, the electronic device 200 may include a sensor module (not illustrated) and/or a camera module (not illustrated) disposed under the display 230. The sensor module may detect the external environment based on information (e.g., light) received through the display 230. According to an embodiment, the sensor module may include at least one of a receiver, a proximity sensor, an ultrasonic sensor, a gesture sensor, a gyro sensor, an air pressure sensor, a magnetic sensor, an acceleration sensor, a grip sensor, a color sensor, an infrared (IR) sensor, a biometric sensor, a temperature sensor, a humidity sensor, a motor encoder, or an indicator. According to an embodiment, at least some sensor modules of the electronic device 200 may be visually exposed from outside through a partial area of the display 230. According to an embodiment, the electronic device 200 may detect an extraction length (e.g., length d1) using the sensor module. According to an embodiment, the electronic device 200 may generate extraction information regarding the degree of extraction detected by the sensor. For example, the electronic device 200 may detect and/or identify the degree of extraction of the second housing 220 using the extraction information. According to an embodiment, the extraction information may include information regarding the extraction length of the second housing 220.

According to an embodiment, the coupling form of the first housing 210 and the second housing 220 is not limited to the form and coupling illustrated in FIGS. 2A, 2B, 3A, and 3B, and may be implemented by combinations and/or couplings of other shapes or components.

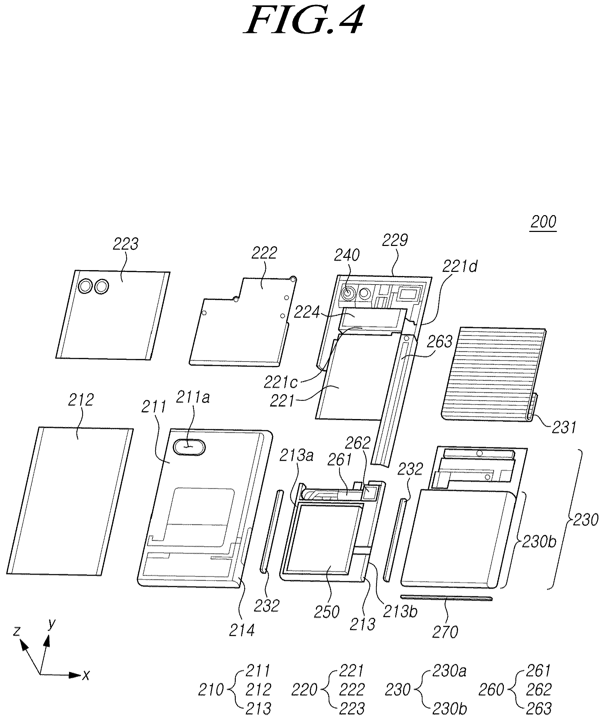

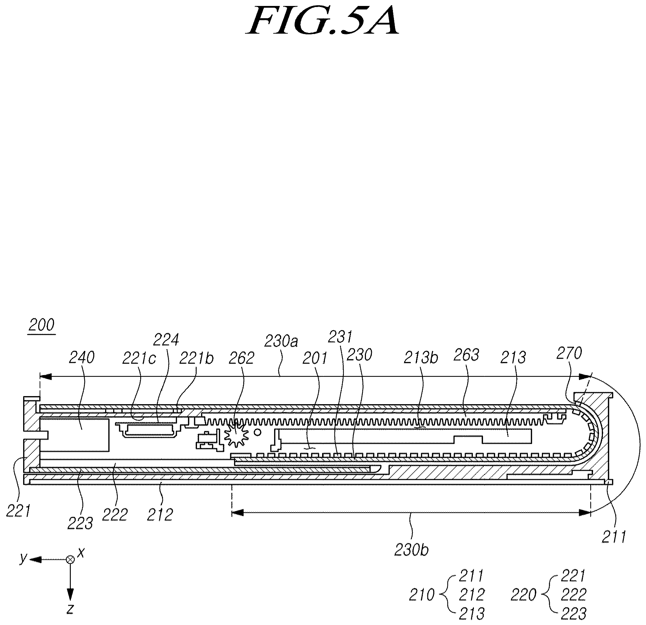

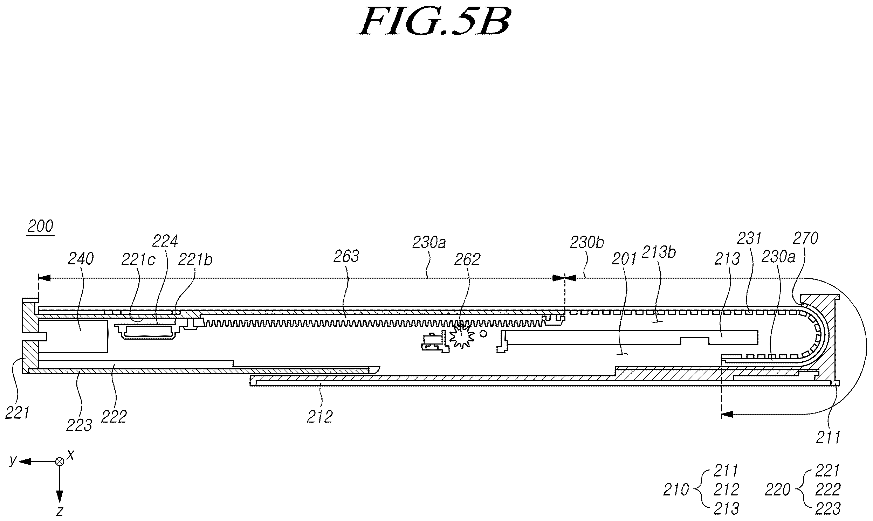

FIG. 4 is an exploded perspective view illustrating an electronic device according to an embodiment. FIG. 5A is a cross-sectional view illustrating an example of cutting the electronic device according to an embodiment along line A-A' of FIG. 2A. FIG. 5B is a cross-sectional view illustrating an example of cutting the electronic device according to an embodiment along line B-B' of FIG. 3A.

Referring to FIGS. 4, 5A, and 5B, an electronic device 200 according to an embodiment may include a housing assembly 210, 220, a display 230, a camera 240, a battery 250 (e.g., the battery 189 of FIG. 1), a driving unit 260, or a foreign substance blocking portion 270. The housing assembly 210, 220 may include a first housing 210 and a second housing 220. According to an embodiment, the first housing 210 and the second housing 220 may be coupled to each other to form an inner space 201 of the electronic device 200. For example, in the first state of the electronic device 200, the second area 230b of the display 230 may be received in the inner space 201.

According to an embodiment, the first housing 210 may include a first supporting member 211, a rear plate 212, and/or a third supporting member 213. According to an embodiment, the first supporting member 211, rear plate 212, and third supporting member 213 included in the first housing 210 may be coupled to each other and may not move in a case where the second housing 220 moves with respect to the first housing 210. According to an embodiment, the first supporting member 211 may form at least a portion of the outer surface of the electronic device 200. For example, the first supporting member 211 may form at least a portion of the side surface of the electronic device 200 and form at least a portion of the rear surface of the electronic device 200. According to an embodiment, the first supporting member 211 may provide a surface on which the rear plate 212 is seated. The rear plate 212 may be seated on one surface of the first supporting member 211.

According to an embodiment, the third supporting member 213 may support internal components of the electronic device 200. For example, the third supporting member 213 may receive the battery 250 and the motor 261 of the driving unit 260. The battery 250 and the motor 261 may be received in at least one of recesses or holes included in the third supporting member 213. According to an embodiment, the third supporting member 213 may be surrounded by the first supporting member 211. For example, in the first state of the electronic device 200, one surface 213a of the third supporting member 213 where the battery 250 is disposed may face the first supporting member 211 and/or the second area 230b of the display 230. As another example, in the first state of the electronic device 200, the other surface 213b of the third supporting member 213 facing a direction opposite to the one surface 213a of the third supporting member 213 may face the first area 230a of the display 230 or the second supporting member 221. For example, the third supporting member 213 may include aluminum as a material, but the disclosure is not limited thereto.

According to an embodiment, the second housing 220 may include a second supporting member 221, a rear cover 222, and/or a slide cover 223. According to an embodiment, the second supporting member 221, rear cover 222, and slide cover 223 may be coupled to each other and may move together with the second housing 220 in a case where the second housing 220 moves with respect to the first housing 210. The second supporting member 221 may support internal components of the electronic device 200. For example, a printed circuit board 224 on which electronic components (e.g., the processor 120 of FIG. 1) of the electronic device 200 are disposed and/or the camera 240 may be disposed on one surface 221c of the second supporting member 221 facing the inner space 201. The other surface 221d of the second supporting member 221 facing a direction opposite to the one surface 221c of the second supporting member 221 may face the first area 230a of the display 230 in a case where the electronic device 200 is in the first state. According to an embodiment, the rear cover 222 may be coupled to the second supporting member 221 to protect components of the electronic device 200 disposed on the second supporting member 221. For example, the rear cover 222 may cover a portion of the one surface 221c of the second supporting member 221. According to an embodiment, the slide cover 223 may be disposed on the rear cover 222 to form the outer surface of the electronic device 200 together with the rear plate 212 and the first supporting member 211. The slide cover 223 may be coupled to one surface of the rear cover 222 or the second supporting member 221 to protect the rear cover 222 and/or the second supporting member 221.

According to an embodiment, in a case where the electronic device 200 is in the first state, the display 230 may be bent as at least a portion the display 230 is rolled into the inner space 201. According to an embodiment, the display 230 may cover at least a portion of the third supporting member 213 and at least a portion of the second supporting member 221. For example, in a case where the electronic device 200 is in the first state, the display 230 may cover the other surface 221d of the second supporting member 221, pass between the second supporting member 221 and the first supporting member 211, and extend toward the inner space 201. At least a portion of the display 230 may surround at least a portion of the third supporting member 213 after passing between the second supporting member 221 and the first supporting member 211. The display 230 may cover the one surface 213a of the third supporting member 213 in the inner space 201. According to an embodiment, if the second housing 220 moves in the first direction, the second area 230b of the display 230 may be extracted from the inner space 201. For example, as the second housing 220 moves in the second direction, the display 230 may be extracted from the inner space 201 by passing between the second supporting member 221 and the first supporting member 211.

According to an embodiment, the electronic device 200 may include a support bar 231 and a guide rail 232 that support the display 230. For example, the support bar 231 may include a plurality of bars coupled to each other and may be manufactured in a shape corresponding to the shape of the second area 230b of the display 230. According to an embodiment, the support bar 231 may move together with the display 230 as the display 230 moves. According to an embodiment, in the first state where the second area 230b of the display 230 is rolled in the inner space 201, the support bar 231 may be rolled in the inner space 201 together with the second area 230b of the display 230. The support bar 231 may move together with the second area 230b of the display 230 as the second housing 220 moves in the first direction. According to an embodiment, the guide rail 232 may guide the movement of the support bar 231. For example, as the display 230 moves, the support bar 231 may move along the guide rail 232 coupled to the third supporting member 213. According to an embodiment, the guide rail 232 may be coupled to the third supporting member 213 or the first supporting member 211. For example, the guide rail 232 may include a plurality of guide rails 232 disposed to be spaced apart from each other at two opposite edges of the third supporting member 213 that are spaced apart from each other along a third direction (e.g., +x direction) perpendicular to the first direction.

According to an embodiment, the driving unit 260 may provide driving force to the second housing 220 so that the second housing 220 may move relative to the first housing 210. According to an embodiment, the driving unit 260 may include a motor 261, a pinion gear 262, and/or a rack gear 263. The motor 261 may receive power from the battery 250 to provide driving force to the second housing 220. According to an embodiment, the motor 261 may be disposed in the first housing 210 and may not move in a case where the second housing 220 moves with respect to the first housing 210. For example, the motor 261 may be disposed in a recess formed in the third supporting member 213. According to an embodiment, the pinion gear 262 may be coupled to the motor 261 and may be rotated by the driving force provided from the motor 261. According to an embodiment, the rack gear 263 may mesh with the pinion gear 262 and may move according to the rotation of the pinion gear 262. For example, the rack gear 263 may perform linear reciprocating motion in the first direction or the second direction according to the rotation of the pinion gear 262. According to an embodiment, the rack gear 263 may be disposed in the second housing 220. For example, the rack gear 263 may be coupled to the second supporting member 221 included in the second housing 220. According to an embodiment, the rack gear 263 may be movable inside an operating space 213p formed in the third supporting member 213.

According to an embodiment, if the pinion gear 262 rotates along a first rotational direction (e.g., the clockwise direction in FIG. 5A), the rack gear 263 may move in the first direction (e.g., -y direction). If the rack gear 263 moves along the first direction, the second housing 220 coupled to the rack gear 263 may move along the first direction. As the second housing 220 moves along the first direction, the area of the display 230 visible from outside the electronic device 200 may be extended. If the pinion gear 262 rotates along a second rotational direction (e.g., the counterclockwise direction in FIG. 5A), the rack gear 263 may move in the second direction (e.g., +y direction). If the rack gear 263 moves along the second direction, the second housing 220 coupled to the rack gear 263 may move along the second direction. As the second housing 220 moves along the second direction, the area of the display 230 visible from outside the electronic device 200 may be reduced.

In the above description, it is described that the motor 261 and pinion gear 262 are disposed in the first housing 210, and the rack gear 263 is disposed in the second housing 220, but embodiments may not be limited thereto. According to embodiments, the motor 261 and pinion gear 262 may be disposed in the second housing 220, and the rack gear 263 may be disposed in the first housing 210.

According to an embodiment, the foreign substance blocking portion 270 may be disposed between the housing assembly 210, 220 and the display 230. The foreign substance blocking portion 270 may be provided to prevent foreign objects from entering the inner space 201 of the electronic device 200 through a gap formed between the housing assembly 210, 220 and the display 230. For example, the foreign substance blocking portion 270 may be disposed between the first housing 210 and the display 230.

According to an embodiment, the foreign substance blocking portion 270 may be fixedly coupled to the housing assembly 210, 220. For example, the foreign substance blocking portion 270 may be fixedly coupled to the first housing 210 as illustrated. The foreign substance blocking portion 270 may move relative to the display 230 during the retraction or extraction operation.

According to an embodiment, the foreign substance blocking portion 270 may be configured to selectively apply a voltage. The foreign substance blocking portion 270 may be configured to have a variable thickness by the applied voltage. For example, if a voltage is applied to the foreign substance blocking portion 270, the thickness of at least a portion of the foreign substance blocking portion 270 may increase or decrease.

The foreign substance blocking portion 270 may include an electro-active polymer (EAP) so that the thickness varies according to whether the voltage is applied. The electro-active polymer may refer to a material that generates physical deformation by electrical signals. The electro-active polymer may include an ionic electro-active polymer. The ionic electro-active polymer may have, e.g., a structure in which electrodes are formed on two opposite side surfaces of a polymer including an electrolyte. If a voltage is applied to the ionic electro-active polymer, the shape may be deformed due to the movement of ions inside the polymer. The ionic electro-active polymer may include a conductive polymer, an ionic polymer gel, an ionic polymer-metal composite (IPMC), a carbon nanotube (CNT), a liquid crystalline polymer, or an electrorheological fluid. However, without limitations thereto, the electro-active polymer may include an electronic electro-active polymer.

In FIGS. 2A to 5B, an embodiment has been illustrated or described for a structure in which the display 230 extends or contracts in the vertical direction. However, this is exemplary, and it may be possible to change and apply the structure of the first housing 210 and the second housing 220 so that the display 230 extends or contracts in the horizontal direction.

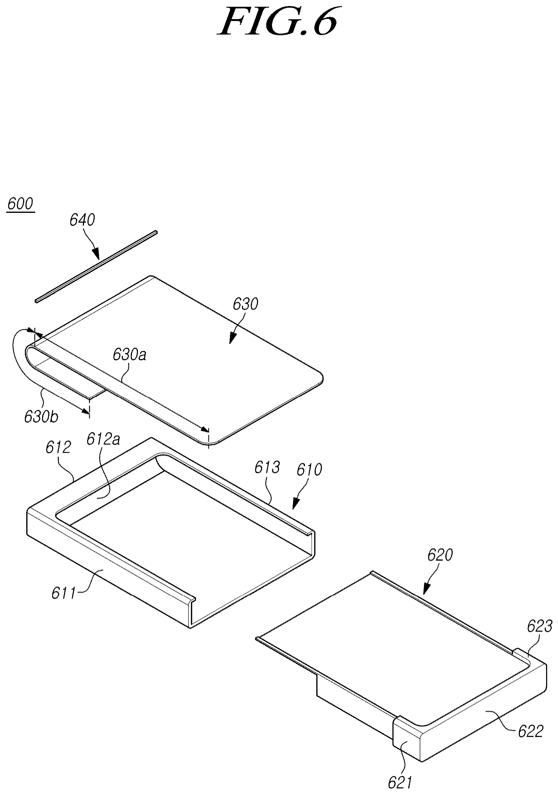

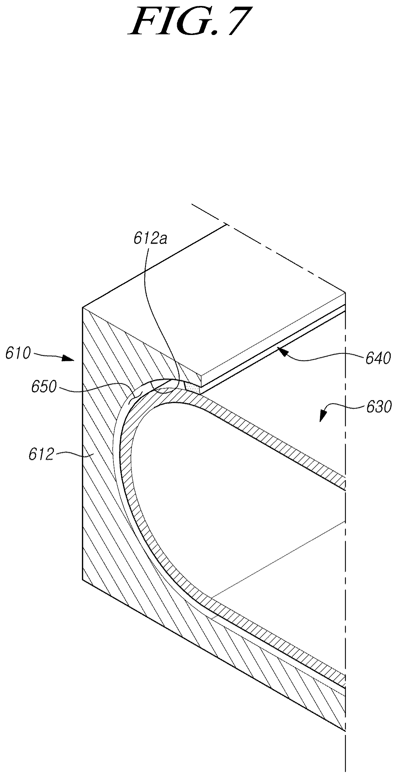

FIG. 6 is a view illustrating an exploded state of some components of an electronic device according to an embodiment. FIG. 7 is a cross-sectional perspective view illustrating an electronic device according to an embodiment.

FIGS. 6 and 7 omit the internal structure of the electronic device 600 (e.g., the electronic device 101 of FIG. 1 or the electronic device 200 of FIG. 2A) for convenience of description. The internal structure of the electronic device 600 may be substantially identical or similar to the internal structure of the electronic device 200 described in connection with FIGS. 2A to 5B. FIG. 7 is a view illustrating an enlarged state of the foreign substance blocking portion 640 and its surrounding components among the components of the electronic device 600.

Referring to FIGS. 6 and 7, the electronic device 600 may include at least one of a housing assembly 610, 620, a flexible display 630, or a foreign substance blocking portion 640. The housing assembly 610, 620 may include a first housing 610 and a second housing 620. The housing assembly 610, 620 of FIG. 6 may be a component substantially identical or similar to the housing assembly 210, 220 of FIG. 2A. The flexible display 630 of FIG. 6 may be a component substantially identical or similar to the display 230 of FIG. 2A. The foreign substance blocking portion 640 of FIG. 6 may be a component substantially identical or similar to the foreign substance blocking portion 270 of FIG. 4. Hereinafter, descriptions of overlapping content are omitted.

According to an embodiment, the first housing 610 may include at least one of a first side portion 611, a second side portion 612, or a third side portion 613. The first side portion 611 may have a first length along a first length direction. The second side portion 612 may extend in a direction substantially perpendicular from the first side portion 611. The second side portion 612 may extend to have a second length equal to or different from the first length. The third side portion 613 may extend in a direction substantially parallel to the first side portion 611. The third side portion 613 may have the first length along the first length direction. The first side portion 611, the second side portion 612, and the third side portion 613 may be disposed to be visible from the outside. At least some of the outer surfaces of the first side portion 611, the second side portion 612, and/or the third side portion 613 may be formed as curved surfaces. The first side portion 611, the second side portion 612, and the third side portion 613 may be formed integrally, but the disclosure is not limited thereto.

According to an embodiment, the second housing 620 may include at least one of a fourth side portion 621, a fifth side portion 622, or a sixth side portion 623. The fourth side portion 621 may have a third length along the first length direction. The length direction of the fourth side portion 621 may be substantially parallel to the length direction of the first side portion 611. The fifth side portion 622 may extend in a direction substantially perpendicular from the fourth side portion 621. The fifth side portion 622 may extend to have a fourth length equal to or different from the third length. The length direction of the fifth side portion 622 may be substantially parallel to the length direction of the second side portion 612. The sixth side portion 623 may extend in a direction substantially parallel to the fourth side portion 621. The sixth side portion 623 may have the third length along the first length direction. The fourth side portion 621, the fifth side portion 622, and the sixth side portion 623 may be disposed to be visible from the outside. At least some of the outer surfaces of the fourth side portion 621, the fifth side portion 622, and/or the sixth side portion 623 may be formed as curved surfaces. The fourth side portion 621, the fifth side portion 622, and the sixth side portion 623 may be formed integrally, but the disclosure is not limited thereto.

According to an embodiment, the flexible display 630 may be configured to be retracted or extracted at a portion adjacent to one side portion among the plurality of side portions 611, 612, 613, 621, 622, 623 of the housing assembly 610, 620. As an example, the flexible display 630 may be configured to be retracted or extracted at the second side portion 612 of the first housing 610 as illustrated, but the disclosure is not limited thereto. The foreign substance blocking portion 640 may be configured to be disposed between one side portion (e.g., the second side portion 612) among the plurality of side portions 611, 612, 613, 621, 622, 623 and the flexible display 630.

According to an embodiment, the flexible display 630 may include a first area 630a(e.g., the first area 230a of FIG. 3A) and a second area 630b(e.g., the second area 230b of FIG. 3A) (e.g., a flexible area). One side of the first area 630a may be fixed, e.g., to the fifth side portion 622 of the second housing 620. The second area 630b may be configured to be retracted or extracted along an inner surface 612a of the second side portion 612 of the first housing 610, for example. However, without limitations thereto, one side of the first area 630a may be fixed to the second side portion 612 of the first housing 610 unlike illustrated, and the second area 630b may be configured to be retracted or extracted along an inner surface of the fifth side portion 622 of the second housing 620.

According to an embodiment, the foreign substance blocking portion 640 may be disposed between the housing assembly 610, 620 and the flexible display 630. For example, the foreign substance blocking portion 640 may be disposed between the first housing 610 and the flexible display 630. As an example, the foreign substance blocking portion 640 may be disposed adjacent to the second side portion 612 of the first housing 610. The foreign substance blocking portion 640 may be fixedly coupled to the second side portion 612 of the first housing 610. As an example, the foreign substance blocking portion 640 may be disposed to extend along the second side portion 612 of the first housing 610. As an example, the foreign substance blocking portion 640 may contact the inner surface 612a of the second side portion 612. However, without limitations thereto, in a case where the second area 630b of the flexible display 630 is retracted or extending from the fifth side portion 622 side of the second housing 620 unlike illustrated, the foreign substance blocking portion 640 may be disposed adjacent to the fifth side portion 622 of the second housing 620.

According to an embodiment, the foreign substance blocking portion 640 may be disposed at a location adjacent to the second area 630b of the flexible display 630. For example, the foreign substance blocking portion 640 may be disposed at a portion where the flexible display 630 is retracted into or extracted from the interior of the electronic device 600. For example, the foreign substance blocking portion 640 may be disposed to extend in a direction perpendicular to a sliding direction of the second housing 620.

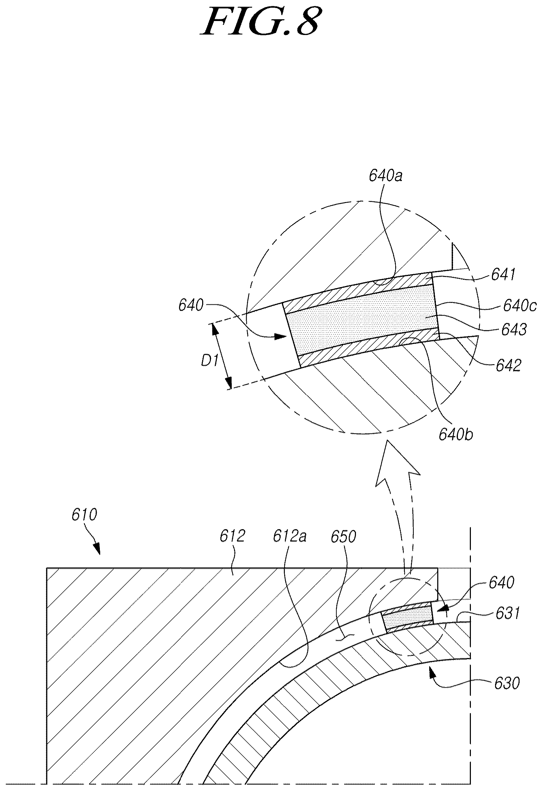

According to an embodiment, a gap (e.g., the gap 650 of FIG. 8) may be formed between the second area 630b and the housing assembly 610, 620 for the second area 630b of the flexible display 630 to be retracted into or extracted from the housing assembly 610, 620. Such a gap 650 may be provided to prevent the surface from being scratched by friction in a case where the flexible display 630 is retracted into or extracted from the interior of the housing assembly 610, 620. The gap 650 may communicate with an inner space of the housing assembly 610, 620. Therefore, foreign objects may enter the housing assembly 610, 620 from the outside through the gap 650. The foreign substance blocking portion 640 may be provided to block the gap 650 to prevent ingress of foreign objects.

According to an embodiment, the electronic device 600 may further include an insulating member (not illustrated). The insulating member may be disposed to insulate between the housing assembly 610, 620 and the foreign substance blocking portion 640. As an example, the insulating member may be disposed between the first housing 610 and the foreign substance blocking portion 640. As an example, one surface of the insulating member may contact the inner surface 612a of the second side portion 612 of the first housing 610 and the other surface may be disposed to contact the foreign substance blocking portion 640.

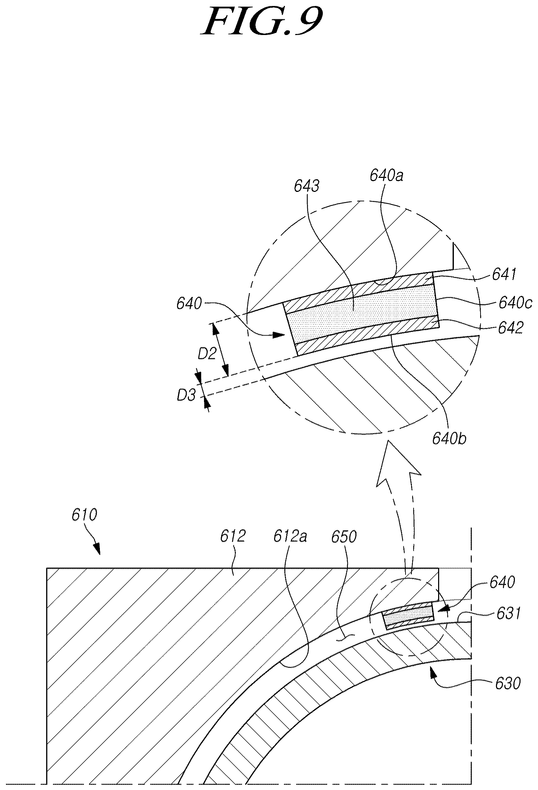

FIGS. 8 and 9 are partial cross-sectional views illustrating an electronic device according to an embodiment.

FIGS. 8 and 9 may be cross-sectional views illustrating a portion of an electronic device (e.g., the electronic device 101 of FIG. 1, the electronic device 200 of FIG. 2A, or the electronic device 600 of FIG. 6). Hereinafter, the foreign substance blocking portion 640 and its surrounding components are mainly described. FIG. 8 may be a view illustrating a state in which the electronic device 101, 200, 600 does not perform the retraction or extraction operation, i.e., a state in which the movement of a second housing (e.g., the second housing 220 of FIG. 2A) is fixed. For example, FIG. 8 may be a view illustrating in a case where the electronic device 101, 200, 600 is in a first state (e.g., a contracted state, a closed state, a retracted state, or a slide-in state), or a second state (e.g., an extracted state, an open state, or a slide-out state). For example, FIG. 8 may be a view illustrating in a case where the electronic device 101, 200, 600 is in an intermediate state between the first state and the second state. FIG. 9 may be a view illustrating a state in which the electronic device 101, 200, 600 performs the retraction or extraction operation, i.e., a state in which the second housing 220 slides. Here, the extraction operation may refer to an operation in which the electronic device 101, 200, 600 transitions from the first state to the second state. Here, the retraction operation may refer to an operation in which the electronic device 101, 200, 600 transitions from the second state to the first state.

According to an example, the foreign substance blocking portion 640 may include at least one surface among a first surface 640a, a second surface 640b, or at least one side surface 640c. The first surface 640a may be a surface facing the housing assembly 610, 620. The first surface 640a may face, e.g., the inner surface 612a of the second side portion 612 in the first housing 610. The second surface 640b may be an opposite surface of the first surface 640a. The second surface 640b may be a surface facing the flexible display 630. The second surface 640b may selectively contact or tightly contact to a surface 631 of the flexible display 630, for example. The at least one side surface 640c may be at least one surface connecting the first surface 640a and the second surface 640b.

According to an example, the foreign substance blocking portion 640 may include at least one of a first electrode layer 641, a second electrode layer 642, or an intermediate layer 643. The intermediate layer 643 may be referred to as, e.g., a substrate polymer layer or a polymer layer.

The first electrode layer 641 may be positioned on the first surface 640a. For example, the first electrode layer 641 may be disposed adjacent to the first surface 640a. The second electrode layer 642 may be positioned on the second surface 640b. For example, the second electrode layer 642 may be disposed adjacent to the second surface 640b. The first electrode layer 641 and the second electrode layer 642 may be spaced apart from each other with the intermediate layer 643 therebetween. However, without limitations thereto, at least one of the first electrode layer 641 or the second electrode layer 642 may be positioned adjacent to surfaces other than the first surface 640a and the second surface 640b. The intermediate layer 643 may be configured so that one surface contacts the first electrode layer 641 and another surface contacts the second electrode layer 642. The first electrode layer 641, the second electrode layer 642, and the intermediate layer 643 may be formed integrally, but the disclosure is not limited thereto.

Circuits for applying a voltage to the foreign substance blocking portion 640 may be connected to the first electrode layer 641 and the second electrode layer 642, respectively. If a voltage is applied to the foreign substance blocking portion 640, oxidation-reduction reactions may occur in the first electrode layer 641 and the second electrode layer 642. If the oxidation-reduction reactions occur, ions distributed in the intermediate layer 643 may move for charge balance. The thickness and/or width of the foreign substance blocking portion 640 may vary due to the movement of ions for charge balance.

FIG. 8 illustrates a stationary state of an electronic device (e.g., the electronic device 200 of FIG. 2A). The stationary state of the electronic device (e.g., the electronic device 200 of FIG. 2A) may refer to a state in which the electronic device (e.g., the electronic device 200 of FIG. 2A) maintains the first state or the second state. Alternatively, the stationary state of the electronic device (e.g., the electronic device 200 of FIG. 2A) may refer to a state in which a driving module (e.g., the driving module 400 of FIG. 4) does not operate. Alternatively, the stationary state of the electronic device (e.g., the electronic device 200 of FIG. 2A) may refer to a state in which a second housing (e.g., the second housing 220 of FIG. 2A) does not slide.

Referring to FIG. 8, in a case where the electronic device (e.g., the electronic device 200 of FIG. 2A) is in the stationary state, the foreign substance blocking portion 640 may contact or tightly contact the flexible display 630. The second surface 640b of the foreign substance blocking portion 640 may contact or tightly contact the surface 631 of the flexible display 630. In a case where the electronic device (e.g., the electronic device 200 of FIG. 2A) is in the stationary state, the foreign substance blocking portion 640 may block the gap 650, which is a space formed between the first housing 610 and the flexible display 630. The foreign substance blocking portion 640 tightly contacts the flexible display 630, thereby preventing ingress of foreign objects through the gap 650. Here, the gap 650 may refer to a space between the inner surface 612a of the second side portion 612 and the surface 631 of the flexible display 630.

In a case where the electronic device (e.g., the electronic device 200 of FIG. 2A) is in the stationary state, the foreign substance blocking portion 640 may have a first thickness D1. The first thickness D1 may be substantially the same as the width of the gap 650. The first thickness D1 may be configured, e.g., to be larger than the width of the gap 650 so as to be fitted between the first housing 610 and the flexible display 630.

FIG. 9 illustrates an operational state of an electronic device (e.g., the electronic device 200 of FIG. 2A). The operational state of the electronic device (e.g., the electronic device 200 of FIG. 2A) may refer to a state in which the retraction or extraction operation of the electronic device are in progress. Alternatively, the operational state of the electronic device (e.g., the electronic device 200 of FIG. 2A) may refer to a state in which a driving module (e.g., the driving module 400 of FIG. 4) operates. Alternatively, the operational state of the electronic device (e.g., the electronic device 200 of FIG. 2A) may refer to a state in which a second housing (e.g., the second housing 220 of FIG. 2A) slides.

Referring to FIG. 9, in a case where the electronic device (e.g., the electronic device 200 of FIG. 2A) is in the operational state, the foreign substance blocking portion 640 may be spaced apart from the flexible display 630 by a first interval D3. If the electronic device (e.g., the electronic device 200 of FIG. 2A) enters the operational state, the flexible display 630 is retracted into or extracted from the first housing 610. By spacing the foreign substance blocking portion 640 apart from the flexible display 630, scratching of the surface 631 of the flexible display 630 may be prevented.

The thickness of the foreign substance blocking portion 640 may be decreased, e.g., as a voltage is applied. As an example, the foreign substance blocking portion 640 may have the first thickness D1 if a voltage is not applied, and may be deformed to a second thickness D2 thinner than the first thickness D1 if a voltage is applied. For example, the difference between the first thickness D1 and the second thickness D2 may be substantially the same as the size of the first interval D3. The thickness may be decreased by applying a voltage to the first electrode layer 641 and the second electrode layer 642 of the foreign substance blocking portion 640. However, without limitations thereto, according to the properties or form of the foreign substance blocking portion 640, the thickness in a case where a voltage is not applied may be thinner than the thickness in a case where a voltage is applied.

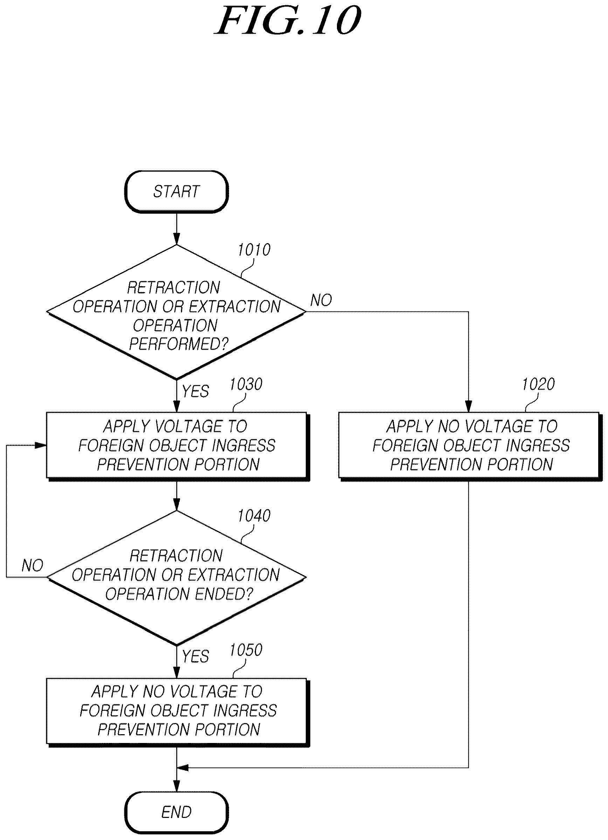

FIG. 10 is a flowchart illustrating a control method of an electronic device according to an embodiment.

Hereinafter, an exemplary control method performed by a processor (e.g., the processor 120 of FIG. 1) that controls an electronic device (e.g., the electronic device 101 of FIG. 1 or the electronic device 200 of FIG. 2A) is described. Using the control method illustrated in FIG. 10, it is possible to prevent a flexible display (e.g., the display 230 of FIG. 2A or the flexible display 630 of FIG. 6) from being scratched by a foreign substance blocking portion (e.g., the foreign substance blocking portion 270 of FIG. 4 or the foreign substance blocking portion 640 of FIG. 6).

Referring to FIG. 10, in operation 1010, the processor 120 may determine whether the electronic device 200 performs the retraction or extraction operation. The processor 120 may determine whether the retraction or extraction operation is performed, e.g., based on whether a command to perform the retraction or extraction operation is input. Alternatively, the processor 120 may determine whether the retraction or extraction operation is performed, e.g., based on whether a driving module (e.g., the driving module 400 of FIG. 4) operates. Alternatively, the processor 120 may determine whether the retraction or extraction operation is performed, e.g., based on whether a second housing (e.g., the second housing 220 of FIG. 2A) slides.

In operation 1020, in a case where the processor 120 determines that the electronic device does not perform the retraction or extraction operation, it may perform control not to apply a voltage to the foreign substance blocking portion 270, 640. If a voltage is not applied to the foreign substance blocking portion 270, 640, the foreign substance blocking portion 270, 640 may maintain a state of contacting or tightly contacting the flexible display 230, 630. As the foreign substance blocking portion 270, 640 block the space entering the interior of the housing, ingress of foreign objects entry may be prevented.

In operation 1030, in a case where the processor 120 determines that the electronic device performs the retraction or extraction operation, it may perform control to apply a voltage to the foreign substance blocking portion 270, 640. For example, the processor 120 may perform control to apply a voltage to the foreign substance blocking portion 270, 640 in response to the sliding movement of the second housing 220. The time in a case where a voltage is applied to the foreign substance blocking portion 270, 640 may be, e.g., a time immediately before the second housing 220 slides, a time in a case where the second housing 220 starts sliding, or a time immediately after the second housing 220 slides, but the disclosure is not limited thereto. For example, the processor 120 may perform control to apply a voltage to the foreign substance blocking portion 270, 640 in response to an operation signal of the driving module 400. The time in a case where a voltage is applied to the foreign substance blocking portion 270, 640 may be, e.g., a time immediately before the driving module 400 starts operating, a time in a case where the driving module 400 starts operating, or a time immediately after the driving module 400 starts operating, but the disclosure is not limited thereto.

If a voltage is applied to the foreign substance blocking portion 270, 640, the thickness of the foreign substance blocking portion 270, 640 including the electro-active polymer is decreased, and the foreign substance blocking portion 270, 640 and the flexible display 230, 630 may be spaced apart from each other. Since the foreign substance blocking portion 270, 640 is spaced apart from the flexible display 230, 630, in a case where the flexible display 230, 630 is retracted into or extracted from a housing (e.g., the first housing 210 of FIG. 2A or the first housing 610 of FIG. 6), scratching due to friction with the foreign substance blocking portion 270, 640 may be prevented.

The operation 1030 may be performed first before the electronic device starts the retraction or extraction operation, but is not limited thereto, and may be performed in response to the retraction or extraction operation.

After the operation 1030, the processor 120 may determine whether the retraction or extraction operation has ended in operation 1040. The processor 120 may continuously apply a voltage to the foreign substance blocking portion 270, 640 to space the foreign substance blocking portion 270, 640 apart from the flexible display 230, 630 while the retraction or extraction operation is in progress.

In operation 1050, in a case where the processor 120 determines that the retraction or extraction operation has ended, it may perform control not to apply a voltage to the foreign substance blocking portion 270, 640. The processor 120 may perform control to release the voltage application so that the foreign substance blocking portion 270, 640 contact or tightly contact the flexible display 230, 630 again as the retraction or extraction operation ends.

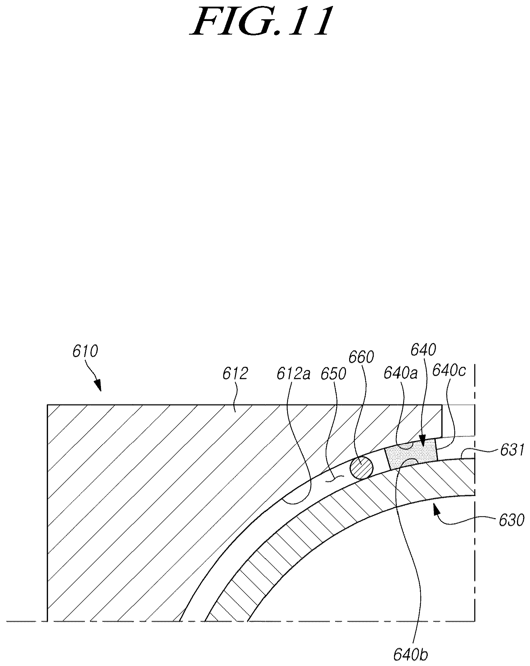

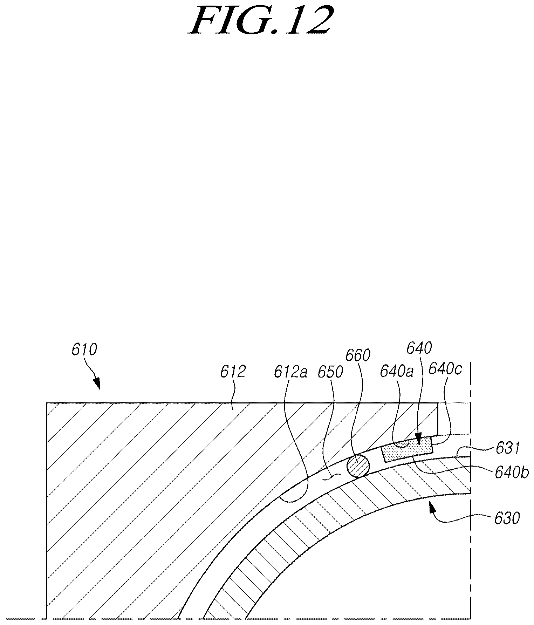

FIGS. 11 and 12 are partial cross-sectional views illustrating an electronic device according to an embodiment.

FIGS. 11 and 12 may be cross-sectional views illustrating a portion of an electronic device (e.g., the electronic device 101 of FIG. 1, the electronic device 200 of FIG. 2A, or the electronic device 600 of FIG. 6). FIG. 11 may be a view illustrating a state in which the electronic device 101, 200, 600 does not perform the retraction or extraction operation, i.e., a state in which the movement of a second housing (e.g., the second housing 220 of FIG. 2A) is fixed. For example, FIG. 11 may be a view illustrating in a case where the electronic device 101, 200, 600 is in a first state (e.g., a contracted state, a closed state, a retracted state, or a slide-in state), or a second state (e.g., an extracted state, an open state, or a slide-out state). For example, FIG. 11 may be a view illustrating in a case where the electronic device 101, 200, 600 is in an intermediate state between the first state and the second state. FIG. 12 may be a view illustrating a state in which the electronic device 101, 200, 600 performs the retraction or extraction operation, i.e., a state in which the second housing 220 slides. Here, the extraction operation may refer to an operation in which the electronic device 101, 200, 600 transitions from the first state to the second state. Here, the retraction operation may refer to an operation in which the electronic device 101, 200, 600 transitions from the second state to the first state.

The same reference numbers are used for the components illustrated in FIGS. 11 and 12, substantially identical or similar to those illustrated in FIGS. 8 and 9. Descriptions of the components denoted by the same reference number are omitted. Hereinafter, an auxiliary foreign substance blocking portion 660 is mainly described.

Referring to FIGS. 11 and 12, an electronic device (e.g., the electronic device 600 of FIG. 6) may further include an auxiliary foreign substance blocking portion 660. The auxiliary foreign substance blocking portion 660 may be configured to rotate in a state of contacting the flexible display 630 as a portion of the flexible display 630 is retracted into or extracted from the housing assemblies, e.g., the first housing 610 of FIG. 6 and the second housing 620 of FIG. 6. The auxiliary foreign substance blocking portion 660 may be composed of, e.g., a fabric or an elastic material, but the disclosure is not limited thereto.

According to an example, the auxiliary foreign substance blocking portion 660 may be disposed more inside the housing assembly 610, 620 than the foreign substance blocking portion 640. For example, the auxiliary foreign substance blocking portion 660 may be disposed to be more adjacent to an inner space of the first housing 610 than the foreign substance blocking portion 640, as illustrated. The auxiliary foreign substance blocking portion 660 may be configured to be disposed to extend parallel to the foreign substance blocking portion 640, e.g., but the disclosure is not limited thereto. As another example, the auxiliary foreign substance blocking portion 660 may be disposed on the same line as the foreign substance blocking portion 640, unlike illustrated. The auxiliary foreign substance blocking portion 660 may be disposed to extend from an end portion of the foreign substance blocking portion 640 along a length direction of the foreign substance blocking portion 640. As another example, the auxiliary foreign substance blocking portion 660 and the foreign substance blocking portion 640 may be alternately disposed along the same line, unlike illustrated.

Referring to FIG. 12, if a voltage is applied to the foreign substance blocking portion 640 for the electronic device 600 to perform the retraction or extraction operation, a space of a predetermined interval may be formed between the foreign substance blocking portion 640 and the flexible display 630. In this case, fine materials may enter through the predetermined interval, and the auxiliary foreign substance blocking portion 660 may serve to filter out such fine materials. The electronic device 600 may prevent fine materials from entering the housing assembly 610, 620 during the retraction or extraction operation by further including the auxiliary foreign substance blocking portion 660.

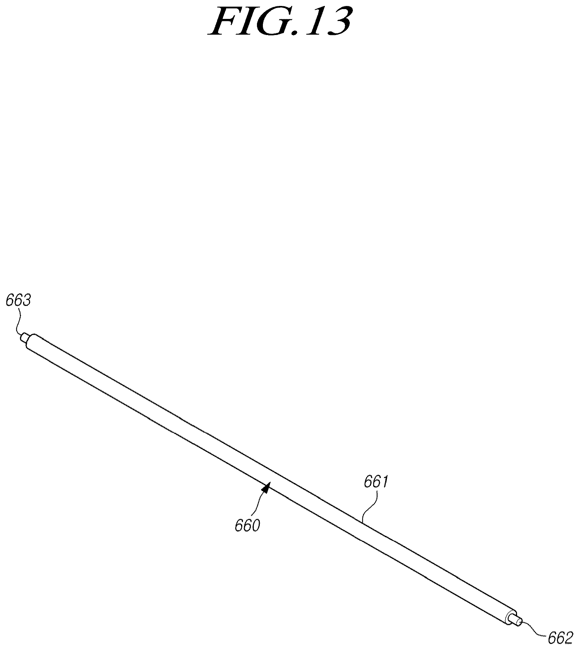

FIG. 13 is a perspective view illustrating an auxiliary foreign substance blocking portion according to an embodiment.

The auxiliary foreign substance blocking portion 660 of FIG. 13 is a perspective view illustrating the auxiliary foreign substance blocking portion 660 illustrated in cross-sectional view in FIGS. 11 and 12.

Referring to FIG. 13, the auxiliary foreign substance blocking portion 660 may include at least one of a rotating portion 661, a first end portion 662, or a second end portion 663. The rotating portion 661 may have a cylindrical shape, but the disclosure is not limited thereto. The rotating portion 661 may be a component that is rotated by friction with a flexible display (e.g., the flexible display 630 of FIG. 11). The rotating portion 661 may rotate together as the flexible display 630 is retracted or extracted. The first end portion 662 and the second end portion 663 may be coupled to the housing assembly (e.g., the first housing 610 of FIG. 6, the second housing 620 of FIG. 6). The first end portion 662 and the second end portion 663 may be coupled so that the auxiliary foreign substance blocking portion 660 is rotatable about the housing assembly 610, 620. As an example, the first end portion 662 and the second end portion 663 may be coupled to the first side portion 611 and the third side portion 613, respectively, of the first housing 610, but the disclosure is not limited thereto.

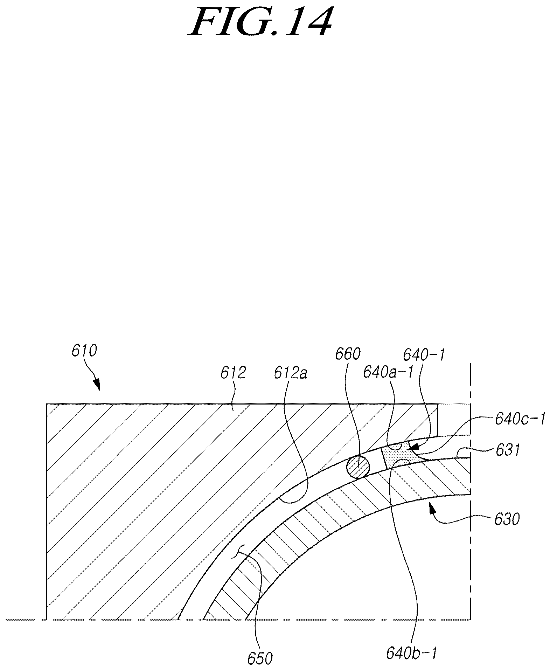

FIG. 14 is a partial cross-sectional view illustrating an electronic device according to an embodiment.

FIG. 14 may be a cross-sectional view illustrating a portion of an electronic device (e.g., the electronic device 101 of FIG. 1, the electronic device 200 of FIG. 2A, or the electronic device 600 of FIG. 6). The same reference numbers are used for the components illustrated in FIG. 14, substantially identical or similar to those illustrated in FIGS. 8, 9, 12, and 13. Descriptions of the components denoted by the same reference number are omitted. Hereinafter, a foreign substance blocking portion 640-1 is mainly described.

Referring to FIG. 14, an electronic device (e.g., the electronic device 600 of FIG. 6) may include a foreign substance blocking portion 640-1. The foreign substance blocking portion 640-1 may include a first electrode layer, an intermediate layer, and a second electrode layer as illustrated in FIG. 8.

According to an example, the foreign substance blocking portion 640-1 may include at least one surface among a first surface 640a-1, a second surface 640b-1, or at least one side surface 640c-1. The first surface 640a-1 may be a surface facing the housing assembly 610, 620. The first surface 640a-1 may face, e.g., the inner surface 612a of the second side portion 612 in the first housing 610. The second surface 640b-1 may be an opposite surface of the first surface 640a-1. The second surface 640b-1 may be a surface facing the flexible display 630. The second surface 640b-1 may selectively contact or tightly contact the surface 631 of the flexible display 630, for example. The at least one side surface 640c-1 may be at least one surface connecting the first surface 640a-1 and the second surface 640b-1.

According to an example, one side surface among the at least one side surface 640c-1 may be formed as a curved surface or an inclined surface. For example, a side surface facing the outside of the housing assembly 610, 620 among the at least one side surface 640c-1 may be formed as a curved surface or an inclined surface. As an example, a side surface facing the outside of the first housing 610 among the at least one side surface 640c-1 may be formed as a curved surface or an inclined surface. Here, the side surface facing the outside may refer to a surface that faces in a case where looking at the gap 650 from outside the electronic device 600. By forming the surface facing the outside of the first housing 610 among the at least one side surface 640c-1 as a curved surface or an inclined surface, foreign objects may be gathered at one point along the slope. If a curved surface or an inclined surface is formed so that foreign objects gathers at one point, the user may easily remove foreign objects accumulated on the foreign substance blocking portion 640.

In an embodiment, the auxiliary foreign substance blocking portion 660 illustrated in FIG. 14 may be omitted.

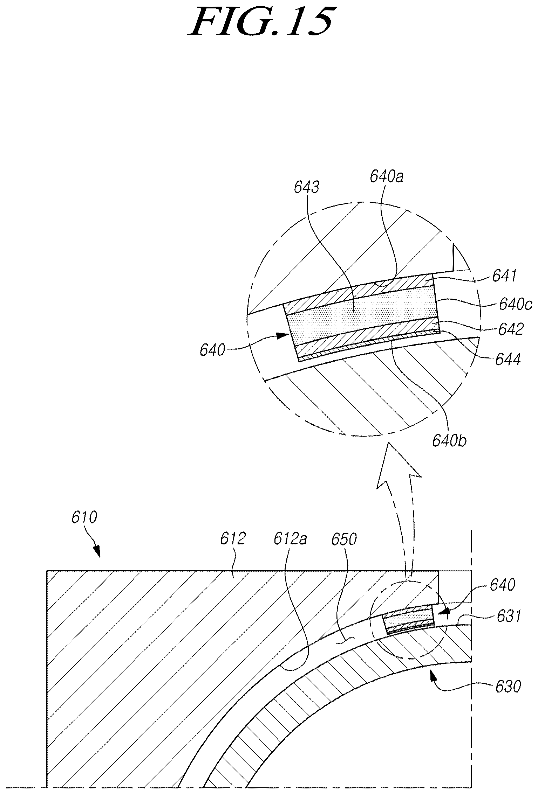

FIG. 15 is a partial cross-sectional view illustrating an electronic device according to an embodiment.

FIG. 15 may be a cross-sectional view illustrating a portion of an electronic device (e.g., the electronic device 101 of FIG. 1, the electronic device 200 of FIG. 2A, or the electronic device 600 of FIG. 6). FIG. 15 illustrates a state in which the foreign substance blocking portion 640 is spaced apart from the flexible display 630 while the flexible display 630 is retracted into or extracted from a housing (e.g., the first housing 610). In a case where the electronic device is in the first state or the second state, the foreign substance blocking portion 640 may contact or tightly contact the flexible display 630 as in FIG. 8. The same reference numbers are used for the components illustrated in FIG. 15, substantially identical or similar to those illustrated in FIGS. 8 and 9. Descriptions of the components denoted by the same reference number are omitted. Hereinafter, an insulator 644 is mainly described.

Referring to FIG. 15, the foreign substance blocking portion 640 may further include the insulator 644. The insulator 644 may be disposed under the second electrode layer 642. One surface of the insulator 644 may contact the second electrode layer 642, and the other surface opposite to the one surface may form the second surface 640b.

The insulator 644 may be disposed to space the second electrode layer 642 and the flexible display 630 apart from each other in a state in which the foreign substance blocking portion 640 contacts or tightly contacts the flexible display 630. By spacing the second electrode layer 642 and the flexible display 630 apart from each other, the insulator 644 may block a current applied to the foreign substance blocking portion 640 from moving to the flexible display 630.

The insulator 644 may be formed of an elastic material. The insulator 644 is a portion that selectively contacts or tightly contacts the flexible display 630, and may have an elastic material to prevent damage to the surface 631 of the flexible display 630. For example, the insulator 644 may include at least one of rubber, silicone gel, polymer, or polyurethane.

According to an embodiment, an electronic device may comprise a housing assembly 210 and 220, 610 and 620 including a first housing 210, 610 and a second housing 220, 620 slidably coupled to the first housing 210, 610,a flexible display 230, 630 disposed on the first housing 210, 610 and the second housing 220, 620, and configured so that a portion the flexible display 230, 630 is bent to be retracted into or extracted from an interior of the housing assembly 210 and 220, 610 and 620 according to a movement of the second housing 220, 620,a foreign substance blocking portion 270, 640 disposed between the housing assembly 210 and 220, 610 and 620 and the flexible display 230, 630 to prevent ingress of a foreign object, and configured to have a variable thickness in response to an applied voltage, and a processor 120 configured to control a voltage applied to the foreign substance blocking portion 270, 640 according to a movement of the second housing 220, 620.

According to an embodiment, the foreign substance blocking portion 270, 640 may include an electro-active polymer.

According to an embodiment, the foreign substance blocking portion 270, 640 may be configured to have a first thickness D1 in case where no voltage is applied and to have a second thickness D2 that is smaller than the first thickness D1 in case where a voltage is applied.

According to an embodiment, in a case where the foreign substance blocking portion 270, 640 has the second thickness D2, the foreign substance blocking portion 270, 640 may be configured to be spaced apart from the flexible display 230, 630 by a predetermined distance.

According to an embodiment, in a case where the foreign substance blocking portion 270, 640 has the first thickness D1, the foreign substance blocking portion 270, 640 may be configured to contact or tightly contact the flexible display 230, 630.

According to an embodiment, the processor 120 may be configured to apply a voltage to the foreign substance blocking portion 270, 640 in response to a sliding movement of the second housing 220, 620 to contract the foreign substance blocking portion 270, 640 and space the foreign substance blocking portion 270, 640 apart from the flexible display 230, 630.

According to an embodiment, the electronic device may further comprise an auxiliary foreign substance blocking portion 660 configured to rotate in a state of contacting the flexible display 230, 630 as a portion of the flexible display 230, 630 is retracted into or extracted from the housing assembly 210 and 220, 610 and 620.

According to an embodiment, the auxiliary foreign substance blocking portion 660 may be composed of a fabric or an elastic material.

According to an embodiment, the auxiliary foreign substance blocking portion 660 may be disposed further inside the housing assembly 210 and 220, 610 and 620 than the foreign substance blocking portion 270, 640.

According to an embodiment, the auxiliary foreign substance blocking portion 660 may be disposed to extend from an end portion of the foreign substance blocking portion 270, 640 along a length direction of the foreign substance blocking portion 270, 640.

According to an embodiment, the auxiliary foreign substance blocking portion 660 may be configured to be disposed to extend parallel to the foreign substance blocking portion 270, 640.

According to an embodiment, the foreign substance blocking portion 270, 640 may be configured to be fixedly coupled to the housing assembly 210 and 220, 610 and 620.

According to an embodiment, a gap is formed between the flexible area and the housing assembly 210 and 220, 610 and 620 for the flexible area of the flexible display 230, 630 to be retracted into or extracted from the housing assembly 210 and 220, 610 and 620, and the foreign substance blocking portion 270, 640 may be disposed to block the gap.

According to an embodiment, the foreign substance blocking portion 270, 640 may include a first surface contacting the housing assembly 210 and 220, 610 and 620, a second surface positioned on an opposite side of the first surface and selectively contacting the flexible display 230, 630, and at least one side surface connecting the first surface and the second surface, and a side surface facing the outside of the housing assembly 210 and 220, 610 and 620 among the at least one side surface may be formed as a curved surface or an inclined surface.

According to an embodiment, the electronic device may further comprise a driving module 400 configured to be disposed in the housing assembly 210 and 220, 610 and 620 to slidingly move the second housing 220, 620.

According to an embodiment, the processor 120 may be configured to apply a voltage to the foreign substance blocking portion 270, 640 in response to an operation signal of the driving module 400.

According to an embodiment, the housing assembly 210 and 220, 610 and 620 may include a plurality of side portions. The flexible display 230, 630 may be configured to be retracted into or extracted from a portion adjacent to one side portion among the plurality of side portions of the housing assembly 210 and 220, 610 and 620.

According to an embodiment, the foreign substance blocking portion 270, 640 may be disposed between the one side portion among the plurality of side portions and the flexible display 230, 630.

According to an embodiment, the foreign substance blocking portion 270, 640 may be disposed to extend in a direction perpendicular to a sliding direction of the second housing 220, 620.

According to an embodiment, the electronic device may further comprise an insulating member disposed so that one surface the insulating member contacts the housing assembly 210 and 220, 610 and 620 and another surface the insulating member contacts the foreign substance blocking portion 270, 640.

The terms as used herein are provided merely to describe some embodiments thereof, but are not intended to limit the disclosure. As used herein, the singular forms "a," "an," and "the" are intended to include the plural forms as well, unless the context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, the term 'and/or' should be understood as encompassing any and all possible combinations by one or more of the enumerated items. As used herein, the terms "include," "have," and "comprise" are used merely to designate the presence of the feature, component, part, or a combination thereof described herein, but use of the term does not exclude the likelihood of presence or adding one or more other features, components, parts, or combinations thereof. As used herein, the terms "first" and "second" may modify various components regardless of importance and/or order and are used to distinguish a component from another without limiting the components.

As used herein, the terms "configured to" may be interchangeably used with the terms "suitable for," "having the capacity to," "designed to," "adapted to," "made to," or "capable of" depending on circumstances. The term "configured to" does not essentially mean "specifically designed in hardware to." Rather, the term "configured to" may mean that a device can perform an operation together with another device or parts. For example, a 'device configured (or set) to perform A, B, and C' may be a dedicated device to perform the corresponding operation or may mean a general-purpose device capable of various operations including the corresponding operation.

Meanwhile, the terms "upper side", "lower side", and "front and rear directions" used in the disclosure are defined with respect to the drawings, and the shape and position of each component are not limited by these terms.

In the disclosure, the above-described description has been made mainly of specific embodiments, but the disclosure is not limited to such specific embodiments, but should rather be appreciated as covering all various modifications, equivalents, and/or substitutes of various embodiments.

## Claims

1. An electronic device comprising:
a housing assembly (210 and 220, 610 and 620) including a first housing (210, 610) and a second housing (220, 620) slidably coupled to the first housing (210, 610);
a flexible display (230, 630) on the first housing (210, 610) and the second housing (220, 620), and configured so that a portion the flexible display (230, 630) is bent to be retracted into or extracted from an interior of the housing assembly (210 and 220, 610 and 620) according to a movement of the second housing (220, 620);
a foreign substance blocking portion (270, 640) between the housing assembly (210 and 220, 610 and 620) and the flexible display (230, 630), and configured to have a variable thickness based on an applied voltage; and
a processor (120) configured to control an amount of voltage applied to the foreign substance blocking portion (270, 640) according to movement of the second housing (220, 620).

2. The electronic device of claim 1, wherein the foreign substance blocking portion (270, 640) includes an electro-active polymer.

3. The electronic device of claim 1 or 2, wherein the foreign substance blocking portion (270, 640) is configured to have a first thickness (D1) in a case where no voltage is applied and to have a second thickness (D2) that is smaller than the first thickness (D1) in a case where a voltage is applied.

4. The electronic device of claim 3, wherein in a case where the foreign substance blocking portion (270, 640) has the second thickness (D2), the foreign substance blocking portion (270, 640) is configured to be spaced apart from the flexible display (230, 630) by a predetermined distance.

5. The electronic device of claim 3, wherein in a case where the foreign substance blocking portion (270, 640) has the first thickness (D1), the foreign substance blocking portion (270, 640) is configured to contact or tightly contact the flexible display (230, 630).

6. The electronic device of any one of claims 1 to 5, wherein the processor (120) is configured to apply a voltage to the foreign substance blocking portion (270, 640) in response to a movement of the second housing (220, 620) to contract the foreign substance blocking portion (270, 640) and space the foreign substance blocking portion (270, 640) apart from the flexible display (230, 630).

7. The electronic device of any one of claims 1 to 6, further comprising an auxiliary foreign substance blocking portion (660) configured to rotate in a state of contacting the flexible display (230, 630) as a portion of the flexible display (230, 630) is retracted into or extracted from the housing assembly (210 and 220, 610 and 620),
wherein the foreign substance blocking portion (270, 640) is configured to be fixedly coupled to the housing assembly (210 and 220, 610 and 620).

8. The electronic device of claim 7, wherein the auxiliary foreign substance blocking portion (660) is disposed further inside the housing assembly (210 and 220, 610 and 620) than the foreign substance blocking portion (270, 640).

9. The electronic device of claim 7, wherein the auxiliary foreign substance blocking portion (660) is disposed to extend from an end portion of the foreign substance blocking portion (270, 640) along a length direction of the foreign substance blocking portion (270, 640).

10. The electronic device of claim 7, wherein the auxiliary foreign substance blocking portion (660) is configured to extend parallel to the foreign substance blocking portion (270, 640).

11. The electronic device of any one of claims 1 to 10, further comprising a driving module (400) configured to be in the housing assembly (210 and 220, 610 and 620) to slidingly move the second housing (220, 620).

12. The electronic device of claim 11, wherein the processor (120) is configured to apply a voltage to the foreign substance blocking portion (270, 640) in response to an operation signal of the driving module (400).

13. The electronic device of any one of claims 1 to 12, wherein the housing assembly (210 and 220, 610 and 620) includes a plurality of side portions,
wherein the flexible display (230, 630) is configured to be retracted into or extracted from a portion adjacent to one side portion among the plurality of side portions of the housing assembly (210 and 220, 610 and 620), and
wherein the foreign substance blocking portion (270, 640) is between the one side portion among the plurality of side portions and the flexible display (230, 630).

14. The electronic device of any one of claims 1 to 13, wherein the foreign substance blocking portion (270, 640) is disposed to extend in a direction perpendicular to a sliding direction of the second housing (220, 620).

15. The electronic device of any one of claims 1 to 14, further comprising an insulating member disposed so that one surface the insulating member contacts the housing assembly (210 and 220, 610 and 620) and another surface the insulating member contacts the foreign substance blocking portion (270, 640).
